# EUROPÄISCHE PATENTSCHRIFT

(11) **EP 2 581 222 B1**
(45) Veröffentlichungstag und Bekanntmachung des Hinweises auf die Patenterteilung: **19.03.2014**
(21) Anmeldenummer: 12187785.6
(22) Anmeldetag: 09.10.2012
(51) Int. Cl.: B32B 17/10, H01L 31/042, H01L 31/048, B32B 27/08, B32B 27/34, B32B 27/30

(54) **Verwendung einer Mehrschichtfolie mit Sauerstoffpermeationssperre für die Herstellung photovoltaischer Module**
Use of a multilayered film with oxygen permeation barrier for the production of photovoltaic modules
Utilisation d'une feuille multicouche avec un blocage de perméation d'oxygène pour la fabrication de modules photovoltaïques

(30) Priorität: 14.10.2011 DE 102011084523
(43) Veröffentlichungstag der Anmeldung: 17.04.2013
(73) Patentinhaber: Evonik Industries AG, 45128 Essen (DE)
(72) Erfinder: Pawlik, Andreas, 45657 Recklinghausen (DE); Wielpütz, Martin, 48308 Senden (DE); Häger, Harald, 59348 Lüdinghausen (DE)

(56) Entgegenhaltungen:
- EP-A1- 2 422 976
- WO-A1-2008/138022
- WO-A1-2011/066595
- WO-A1-2011/068105
- US-A1- 2011 159 280

## Beschreibung

Die Erfindung betrifft die Verwendung von Foliensystemen mit einer Sperrschicht gegen Sauerstoff aus EVOH für die Herstellung von Solarmodulen.

Solarmodule, häufig auch als photovoltaische Module bezeichnet, dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen.

Die aktive Solarzelle befindet sich hierbei zwischen einer Frontabdeckung und einer Rückabdeckung. Die Frontabdeckung ist lichtdurchlässig und besteht im Regelfall aus Glas; sie ist mittels einer Haftvermittlerschicht, die häufig aus einem EthylenVinylacetat-Copolymeren besteht, mit der die Solarzelle enthaltenden Schicht verbunden. Die Rückabdeckung garantiert elektrische Abschirmung und dient als Schutz gegen Witterungseinflüsse, wie UV-Licht, und als Feuchtigkeitsbarriere.

Für die Rückabdeckung werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems. Allerdings weisen derartige Fluorpolymerfolien nur eine geringe Haftung zur Siegelschicht auf, die als Einbettungsmaterial für die Solarzellen selbst verwendet wird. Darüber hinaus trägt die Fluorpolymerfolie nur in untergeordnetem Maß zur elektrischen Isolierung bei, woraus die Notwendigkeit der Verwendung einer vergleichsweise dicken Polyesterfolie resultiert.

In der WO 2008138022 wird daher vorgeschlagen, bei derartigen Verbunden die beiden Fluorpolymerfolien durch Folien aus Polyamid 12 (PA12) zu ersetzen. In einer Weiterbildung hiervon wird in der WO 2011066595 vorgeschlagen, dass die der Solarzelle zugewandte Thermoplastschicht einen Licht reflektierenden Füllstoff wie Titandioxid enthält, während die der Solarzelle abgewandte Thermoplastschicht einen zweiten Füllstoff, wie Glasfasern, Wollastonit oder Glimmer enthält, der eine höhere Wärmeleitfähigkeit dieser Schicht bewirkt. Beispielhafte Thermoplaste entstammen der Gruppe der Polyamide, Polyester oder Blends aus Polyamid und Polyolefin. Explizit genannt werden PA11, PA12 und PA1010 sowie deren Blends mit Polyolefinen.

Besondere Bedeutung kommt dem Schutz der empfindlichen, aktiven Solarzellen zu. Diese bestehen überwiegend aus oxidationsempfindlichem Silizium.

Die Aufgabe der Erfindung ist, den oxidativen Angriff auf die aktiven Solarzellen zu minimieren.

Diese Aufgabe wird gelöst durch die Verwendung einer Mehrschichtfolie als Rückabdeckung eines photovoltaischen Moduls, wobei die Mehrschichtfolie aus folgenden direkt aufeinanderfolgenden Schichten besteht:
a) Eine der Solarzelle zugewandte Schicht aus einer Formmasse, die zu mindestens 70 Gew.-%, vorzugsweise zu mindestens 80 Gew.-% und besonders bevorzugt zu mindestens 90 Gew.-% aus einem Ethylen-Vinylalkohol-Copolymeren (EVOH) besteht;
b) eine Haftvermittlerschicht,
c) eine Mittelschicht aus einer thermoplastischen Formmasse, die Polyamid, Polyolefin und/oder Polyester enthält,
d) optional eine Haftvermittlerschicht sowie
e) eine Außenschicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, bezogen auf die gesamte Formmasse, enthält.

Die Formmasse der Schicht gemäß c) enthält als Thermoplast Polyamid, Polyolefin und/oder Polyester. Darüber hinaus können übliche Hilfs- und Zusatzstoffe enthalten sein, insbesondere Licht- und/oder Wärmestabilisatoren, Licht reflektierende Füllstoffe wie beispielsweise Titandioxid sowie verstärkende Füllstoffe wie beispielsweise Glasfasern, Wollastonit oder Glimmer.

Die Formmasse der Schicht gemäß e) kann entweder eines der nachfolgend genannten Polyamide oder mehrere als Gemisch enthalten. Weiterhin können bis zu 40 Gew.-%, bezogen auf den gesamten Polymeranteil der Formmasse, andere Thermoplaste enthalten sein, beispielsweise schlagzähmachende Kautschuke. Eventuell enthaltene Kautschuke enthalten vorzugsweise, dem Stand der Technik entsprechend, funktionelle Gruppen, mit denen eine Verträglichkeit mit der Polyamidmatrix erhalten wird. Darüber hinaus können die für Polyamide üblichen Hilfs- und Zusatzstoffe enthalten sein, insbesondere Licht- und/oder Wärmestabilisatoren. Hinsichtlich Füllstoffen gilt das Gleiche wie für die Formmasse der Schicht gemäß c). Zusätzlich kann die Formmasse der Schicht gemäß e) eingefärbt sein und/oder ein Mattierungsmittel enthalten.

Der Haftvermittler der Schicht gemäß b) richtet sich nach der Natur der Schicht gemäß c). Besteht diese Schicht aus einer Formmasse auf Basis von Polyamid, Polyester und/oder Polyolefin, so kann der Haftvermittler eine Formmasse sein, die mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-% eines Polyolefins enthält, das 0,1 bis 5 Gew.-%, bevorzugt 0,3 bis 4 Gew.-% und besonders bevorzugt 0,5 bis 4 Gew.-% an Säureanhydridgruppen trägt. Andere geeignete Haftvermittler, insbesondere in Fällen, in denen die Schicht gemäß c) auf Basis von Polyamid oder Polyester aufgebaut ist, enthalten ein Polyamin-Polyamid-Pfropfcopolymer, gegebenenfalls in Kombination mit einem Polyamid, das mit EVOH verträglich ist, etwa PA6, oder die Kombination zweiter Polyamide. Geeignete Zusammensetzungen sind beispielsweise in der EP 1 065 048 A2 sowie in der EP 1 216 826 A1 offenbart. Die Formmasse der Schicht gemäß b) kann zusätzlich Licht- und/oder Wärmestabilisatoren sowie einen Licht reflektierenden Füllstoff wie beispielsweise Titandioxid enthalten (WO 2011066595).

Der Haftvermittler der Schicht gemäß d) kann jede geeignete Zusammensetzung haben. Beispielsweise sind die gleichen Systeme geeignet, die oben für den Haftvermittler der Schicht gemäß b) genannt sind.

EVOH ist seit langem bekannt. Es ist ein Copolymer aus Ethylen und Vinylalkohol und wird manchmal auch als EVAL bezeichnet. Der Ethylengehalt im Copolymeren beträgt in der Regel 25 bis 60 Mol-% und insbesondere 28 bis 45 Mol-%. Eine Vielzahl von Typen ist im Handel erhältlich. Beispielsweise sei auf die Firmenschrift "Introduction to Kuraray EVAL™ Resins", Version 1.2/9810 der Firma Kuraray EVAL Europe verwiesen.

Das Polyamid kann ein teilkristallines Polyamid sein wie beispielsweise PA6, PA66, PA610, PA612, PA10, PA810, PA106, PA1010, PA11, PA1011, PA1012, PA1210; PA1212, PA814, PA1014, PA618, PA512, PA613, PA813, PA914, PA1015, PA11, PA12 oder ein teilaromatisches Polyamid, ein sogenanntes Polyphthalamid (PPA). (Die Kennzeichnung der Polyamide entspricht internationaler Norm, wobei die erste(n) Ziffer(n) die C-Atomzahl des Ausgangsdiamins und die letzte(n) Ziffer(n) die C-Atomzahl der Dicarbonsäure angeben. Wird nur eine Zahl genannt, so bedeutet dies, dass von einer α,ω-Aminocarbonsäure bzw. von dem davon abgeleiteten Lactam ausgegangen worden ist; im übrigen sei verwiesen auf H. Domininghaus, Die Kunststoffe und ihre Eigenschaften, Seiten 272 ff., VDI-Verlag, 1976.) Geeignete PPAs sind beispielsweise PA66/6T, PA6/6T, PA6T/MPMDT (MPMD steht für 2-Methylpentamethylendiamin), PA9T, PA10T, PA11T, PA12T, PA14T sowie Copolykondensate dieser letzten Typen mit einem aliphatischen Diamin und einer aliphatischen Dicarbonsäure oder mit einer ω-Aminocarbonsäure bzw. einem Lactam. Teilkristalline Polyamide besitzen eine Schmelzenthalpie von mehr als 25 J/g, gemessen mit der DSC-Methode gemäß ISO 11357 beim 2. Aufheizen und Integration des Schmelzpeaks.

Das Polyamid kann aber auch ein semikristallines Polyamid sein. Semikristalline Polyamide besitzen eine Schmelzenthalpie von 4 bis 25 J/g, gemessen mit der DSC-Methode gemäß ISO 11357 beim 2. Aufheizen und Integration des Schmelzpeaks. Beispiele für geeignete semikristalline Polyamide sind
- Das Polyamid aus 1,10-Decandisäure oder 1,12-Dodecandisäure und 4,4'-Diaminodicyclohexylmethan (PA PACM10 und PA PACM12), ausgehend von einem 4,4'-Diaminodicyclohexylmethan mit einem trans,trans-Isomerenanteil von 35 bis 65 %;
- Copolymere auf Basis der obengenannten teilkristallinen Polyamide; sowie
- Blends aus den obengenannten teilkristallinen Polyamiden und einem damit verträglichen amorphen Polyamid.

Das Polyamid kann auch ein amorphes Polyamid sein. Amorphe Polyamide besitzen eine Schmelzenthalpie von weniger als 4 J/g, gemessen mit der DSC-Methode gemäß ISO 11357 beim 2. Aufheizen und Integration des Schmelzpeaks. Beispiele für amorphe Polyamide sind:
- das Polyamid aus Terephthalsäure und/oder Isophthalsäure und dem Isomerengemisch aus 2.2.4- und 2.4.4-Trimethylhexamethylendiamin,
- das Polyamid aus Isophthalsäure und 1.6-Hexamethylendiamin,
- das Copolyamid aus einem Gemisch aus Terephthalsäure/Isophthalsäure und 1.6-Hexamethylendiamin, gegebenenfalls in Mischung mit 4.4'-Diaminodicyclohexylmethan,
- das Copolyamid aus Terephthalsäure und/oder Isophthalsäure, 3.3'-Dimethyl-4.4'-diaminodicyclohexylmethan und Laurinlactam oder Caprolactam,
- das (Co)Polyamid aus 1.12-Dodecandisäure oder Sebacinsäure, 3.3'-Dimethyl-4.4'-diaminodicyclohexylmethan und gegebenenfalls Laurinlactam oder Caprolactam,
- das Copolyamid aus Isophthalsäure, 4.4'-Diaminodicyclohexylmethan und Laurinlactam oder Caprolactam,
- das Polyamid aus 1.12-Dodecandisäure und 4.4'-Diaminodicyclohexylmethan (bei niedrigem trans,trans-Isomerenanteil),
- das (Co)Polyamid aus Terephthalsäure und/oder Isophthalsäure sowie einem alkylsubstituierten Bis(4-aminocyclohexyl)methan-Homologen, gegebenenfalls in Mischung mit Hexamethylendiamin,
- das Copolyamid aus Bis(4-amino-3-methyl-5-ethyl-cyclohexyl)methan, gegebenenfalls zusammen mit einem weiteren Diamin, sowie Isophthalsäure, gegebenenfalls zusammen mit einer weiteren Dicarbonsäure,
- das Copolyamid aus einer Mischung von m-Xylylendiamin und einem weiteren Diamin, z. B. Hexamethylendiamin, sowie Isophthalsäure, gegebenenfalls zusammen mit einer weiteren Dicarbonsäure wie z. B. Terephthalsäure und/oder 2,6-Naphthalindicarbonsäure,
- das Copolyamid aus einer Mischung von Bis(4-amino-cyclohexyl)methan und Bis-(4-amino-3-methyl-cyclohexyl)methan sowie aliphatischen Dicarbonsäuren mit 8 bis 14 C-Atomen, sowie
- Polyamide oder Copolyamide aus einer Mischung, die 1.14-Tetradecandisäure sowie ein aromatisches, arylaliphatisches oder cycloaliphatisches Diamin enthält.

Diese Beispiele können durch Hinzunahme weiterer Komponenten (z. B. Caprolactam, Laurinlactam oder Diamin/Dicarbonsäure-Kombinationen) oder durch teilweisen oder vollständigen Ersatz von Ausgangskomponenten durch andere Komponenten weitestgehend variiert werden.

Polyetheresteramide sind z. B. aus der DE-A-25 23 991 und der DE-A-27 12 987 bekannt; sie enthalten als Comonomer ein Polyetherdiol. Polyetheramide sind beispielsweise aus der DE-A- 30 06 961 bekannt; sie enthalten als Comonomer ein Polyetherdiamin.

Beim Polyetherdiol bzw. dem Polyetherdiamin kann die Polyethereinheit beispielsweise auf 1.2-Ethandiol, 1.2-Propandiol, 1.3-Propandiol, 1.4-Butandiol oder 1.3-Butandiol basieren. Die Polyethereinheit kann auch gemischt aufgebaut sein, etwa mit statistischer oder blockweiser Verteilung der von den Diolen herrührenden Einheiten. Das Gewichtsmittel der Molmasse der Polyetherdiole bzw. Polyetherdiamine liegt bei 200 bis 5000 g/mol und vorzugsweise bei 400 bis 3000 g/mol; ihr Anteil am Polyetheresteramid bzw. Polyetheramid beträgt bevorzugt 4 bis 60 Gew.-% und besonders bevorzugt 10 bis 50 Gew.-%. Geeignete Polyetherdiamine sind durch Konversion der entsprechenden Polyetherdiole durch reduktive Aminierung oder Kupplung an Acrylnitril mit nachfolgender Hydrierung zugänglich; sie sind z. B. in Form der JEFFAMIN^{®} D- oder ED-Typen oder der ELASTAMINE^{®}-Typen bei der Huntsman Corp. oder in Form der Polyetheramin D-Reihe bei der BASF SE kommerziell erhältlich. In geringeren Mengen kann auch ein Polyethertriamin mit verwendet werden, z. B. ein JEFFAMIN^{®} T-Typ, falls ein verzweigtes Polyetheramid eingesetzt werden soll. Vorzugsweise setzt man Polyetherdiamine bzw. Polyethertriamine ein, die pro Ethersauerstoffatom im Mittel mindestens 2,3 Kohlenstoffatome in der Kette enthalten. Erfindungsgemäß sind Polyetheramide wegen der besseren Hydrolysebeständigkeit bevorzugt.

Als thermoplastischer Polyester kommen linear aufgebaute, thermoplastische Polyester infrage. Diese werden durch Polykondensation von Diolen mit Dicarbonsäure bzw. deren polyesterbildenden Derivaten wie Dimethylestern hergestellt. Geeignete Diole haben die Formel HO-R-OH, wobei R einen divalenten, verzweigten oder unverzweigten aliphatischen und/oder cycloaliphatischen Rest mit 2 bis 40, vorzugsweise 2 bis 12, C-Atomen darstellt. Geeignete Dicarbonsäuren haben die Formel HOOC-R'-COOH, wobei R' einen divalenten aromatischen Rest mit 6 bis 20, vorzugsweise 6 bis 12, C-Atomen bedeutet.

Als Beispiel für Diole seien Ethylenglykol, Trimethylenglykol, Tetramethylenglykol, Hexamethylenglykol, Neopentylglykol, Cyclohexandimethanol sowie das C₃₆-Diol Dimerdiol genannt. Die Diole können alleine oder als Diolgemisch eingesetzt werden. Bis zu 25 Mol-% des genannten Diols können durch ein Polyalkylenglykol mit nachstehender allgemeiner Formel ersetzt sein, 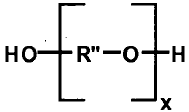 wobei R" einen zweiwertigen Rest mit 2 bis 4 C-Atomen bedeutet und x einen Wert von 2 bis 50 annehmen kann.

Als aromatische Dicarbonsäuren kommen z. B. Terephthalsäure, Isophthalsäure, 1.4-, 1.5-, 2.6- bzw. 2.7-Naphthalindicarbonsäure, Diphensäure und Diphenylether-4.4'-dicarbonsäure infrage. Bis zu 30 Mol-% dieser Dicarbonsäuren können durch aliphatische oder cycloaliphatische Dicarbonsäuren wie z. B. Bernsteinsäure, Adipinsäure, Sebacinsäure, Dodecandisäure oder Cyclohexan-1.4-dicarbonsäure ersetzt sein.

Beispiele für geeignete Polyester sind Polyethylenterephthalat, Polypropylenterephthalat, Polybutylenterephthalat, Polyethylen-2.6-naphthalat, Polypropylen-2.6-naphthalat und Polybutylen-2.6-naphthalat.

Die Herstellung dieser Polyester gehört zum Stand der Technik (DE-OSS 24 07 155, 24 07 156; Ullmanns Encyclopädie der technischen Chemie, 4. Aufl., Bd. 19, Seiten 65 ff., Verlag Chemie, Weinheim, 1980).

Das Polyolefin kann beispielsweise ein Polyethylen oder bevorzugt ein Polypropylen sein. Das Polypropylen kann grundsätzlich jeder handelsübliche Polypropylentyp sein, beispielsweise isotaktisches oder syndiotaktisches Homopolypropylen, ein Randomcopolymer von Propen mit Ethen und/oder Buten-1, ein Propen-Ethen-Blockcopolymer und dergleichen. Das Polypropylen kann nach jedem bekannten Verfahren hergestellt werden, beispielsweise nach Ziegler-Natta oder mittels Metallocenkatalyse. Es kann eine Schlagzähkomponente wie z. B. EPM- oder EPDM-Kautschuk oder SEBS enthalten.

Hinsichtlich Polyamin-Polyamid-Pfropfcopolymerer sei auf die Offenbarung der EP 1 065 048 A2 verwiesen.

Die einzelnen Folienschichten weisen in der Regel folgende Dicken auf:
- Schicht gemäß a): 50 bis 250 µm und vorzugsweise 100 bis 200 µm;
- Schicht gemäß b): 15 bis 100 µm und vorzugsweise 25 bis 50 µm;
- Schicht gemäß c): 100 bis 500 µm und vorzugsweise 150 bis 400 µm;
- Schicht gemäß d): 3 bis 40 µm und vorzugsweise 5 bis 25 µm.
- Schicht gemäß e): 15 bis 100 µm und vorzugsweise 25 bis 50 µm;

Die erfindungsgemäß verwendete Mehrschichtfolie ist im Hinblick auf möglichst geringe Anzahl von Schichten bei generell guter Haftung optimiert. Sie kann nach allen Methoden des Standes der Technik hergestellt werden, beispielsweise durch Coextrusion oder Laminieren. Sie wird mit der Siegelschicht, in die die Solarzelle eingebettet ist, beispielsweise durch Laminieren oder Kleben verbunden. Wegen des EVOH-Anteils in der Schicht gemäß a) wird beim Laminieren eine gute Haftung zur Siegelschicht erhalten. Als Siegelschicht kann jedes gemäß dem Stand der Technik gebräuchliche Material verwendet werden.

Gegenstand der Erfindung ist auch ein photovoltaisches Modul, das unter Verwendung der anspruchsgemäßen Mehrschichtfolie als Rückabdeckung hergestellt wurde.

Die Erfindung wird nachfolgend beispielhaft erläutert. Hierzu wurden folgende Formmassen hergestellt; bei "Teilen" handelt es sich immer um Gewichtsteile.

### Compound für Schicht A (O₂-Barriere):

95 Teile EVAL^{™} F101 B der Fa. Kuraray und 5 Teile des Titandioxids Sachtleben R 420 wurden mit Hilfe eines Zweiwellenextruderes (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound für Schicht B (Haftvermittler):

59,3 Teile PA612, 18 Teile PA6, 2 Teile Polyamin-Polyamid-Pfropfcopolymer (hergestellt gemäß EP 1 065 236 A2 aus 87,063 Gew.-% Laurinlactam, 0,164 Gew.-% Dodecandisäure, 8,205 Gew.-% Lupasol^{®} G 100 50%ig, 0,010 Gew.-% unterphosphorige Säure 50%ig sowie 4,558 Gew.-% VE-Wasser), 0,5 Teile IRGANOX^{®} 1098 (ein sterisch gehindertes phenolisches Antioxidans), 0,2 Teile TINUVIN^{®} 312 (UV-Absorber) und 20 Teile des Titandioxids Sachtleben R 420 wurden mit Hilfe eines Zweiwellenextruders (Coperion Werner & Pfleiderer ZSK 25 WLE; 36 L/D) bei einer Zylindertemperatur von 240 °C gemischt. Der Strang wurde mit Hilfe eines Wasserbads gekühlt und geschnitten; das Granulat wurde anschließend 12 Stunden bei 80 °C im Umluftofen getrocknet.

### Compound für Schicht C (Mittelschicht):

75,6 Teile Hostalen^{®} EPD60R (Propylen-Ethylen-Blockcopolymer), 4 Teile LOTADER^{®} AX 8900 (Terpolymer aus Ethylen, Methylacrylat und Glycidylmethacrylat), 20 Teile Kaolin TEC 110 und 0,4 Teile IRGANOX^{®} 1010 (sterisch gehindertes phenolisches Antioxidans) wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Compound für Schicht D (Haftvermittler):

55,6 Teile Hostalen^{®} EPD60R, 40 Teile VESTAMID^{®} L1901 (PA12), 4 Teile LOTADER^{®} AX 8900 und 0,4 Teile IRGANOX^{®} 1010 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Compound für Schicht E (Außenschicht, Modulrückseite):

79,3 Teile VESTAMID^{®} L1901 nf, 0,5 Teile IRGANOX^{®} 1098, 0,2 Teile TINUVIN^{®} 312 und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Extrusion mehrschichtiger Folien:

Mit einer Mehrschichtfolienanlage der Fa. Collin (Co-Extrusionsfeedblock für 5-schichtige Folien) wurde eine fünf- und eine vierschichtige Folie hergestellt (Verarbeitungstemperatur ca. 230 °C). Die Schichtdickenverteilung wurde wie folgt eingestellt:

| | |
|---|---|
| A / B / C / D / E: | 100 µm / 50 µm / 150 µm / 20 µm / 50 µm |
| B / C / D / E: | 50 µm / 150 µm / 20 µm / 50 µm (Vergleich ohne Schicht A) |

Die Ergebnisse sind in der Tabelle 1 dargestellt.

**Tabelle 1: Beispiele; O₂-Permeation gemäß ISO 15105-2 bei 23 °C und 50 % r. F. in cm³/(m² · d · bar)**

| | Schichtenverteilung | O₂-Permeation |
|---|---|---|
| Beispiel | A / B / C / D / E | 0,4 |
| Vergleichsbeispiel 1 | B / C / D / E | 74 |

## Patentansprüche

1. Verwendung einer Mehrschichtfolie als Rückabdeckung eines photovoltaischen Moduls, wobei die Mehrschichtfolie direkt aufeinanderfolgend aus folgenden Schichten besteht:
a) Eine der Solarzelle zugewandte Schicht aus einer Formmasse, die zu mindestens 70 Gew.-% aus einem Ethylen-Vinylalkohol-Copolymeren (EVOH) besteht,
b) eine Haftvermittlerschicht,
c) eine Mittelschicht aus einer thermoplastischen Formmasse, die Polyamid, Polyolefin und/oder Polyester enthält,
d) optional eine Haftvermittlerschicht sowie
e) eine Außenschicht aus einer Formmasse, die einen Polyamidanteil von mindestens 35 Gew.-%, bezogen auf die Formmasse, enthält.

2. Verwendung gemäß Anspruch 1,
**dadurch gekennzeichnet, dass**
- die Schicht gemäß a) eine Dicke von 50 bis 250 µm besitzt,
- die Schicht gemäß b) eine Dicke von 15 bis 100 µm besitzt,
- die Schicht gemäß c) eine Dicke von 100 bis 500 µm besitzt,
- die Schicht gemäß d) eine Dicke von 3 bis 40 µm besitzt und
- die Schicht gemäß e) eine Dicke von 15 bis 100 µm besitzt.

3. Photovoltaisches Modul, erhalten unter Verwendung einer Mehrschichtfolie gemäß einem der vorhergehenden Ansprüche als Rückabdeckung.

## Claims

1. Use of a multilayer film as a back cover of a photovoltaic module, said multilayer film consisting of the following layers in direct succession:
a) a solar cell-facing layer of a moulding composition consisting of at least 70% by weight of an ethylene-vinyl alcohol copolymer (EVOH),
b) an adhesion promoter layer,
c) a middle layer of a thermoplastic moulding composition comprising polyamide, polyolefin and/or polyester,
d) optionally an adhesion promoter layer, and#
e) an outer layer of a moulding composition comprising a polyamide content of at least 35% by weight, based on the moulding composition.

2. Use according to Claim 1,
**characterized in that**
- the layer according to a) has a thickness of 50 to 250 µm,
- the layer according to b) has a thickness of 15 to 100 µm,
- the layer according to c) has a thickness of 100 to 500 µm,
- the layer according to d) has a thickness of 3 to 40 µm and
- the layer according to e) has a thickness of 15 to 100 µm.

3. Photovoltaic module obtained using a multilayer film according to either of the preceding claims as a back cover.

## Revendications

1. Utilisation d'une feuille multicouche en tant que revêtement arrière d'un module photovoltaïque, la feuille multicouche étant constituée par les couches suivantes directement successives :
a) une couche orientée vers la cellule solaire en un matériau de moulage constitué à hauteur d'au moins 70 % en poids par un copolymère éthylène-alcool vinylique (EVOH),
b) une couche de promoteur d'adhésion,
c) une couche intermédiaire en un matériau de moulage thermoplastique qui contient un polyamide, une polyoléfine et/ou un polyester,
d) éventuellement une couche de promoteur d'adhésion, et
e) une couche extérieure en un matériau de moulage qui contient une proportion de polyamide d'au moins 35 % en poids, par rapport au matériau de moulage.

2. Utilisation selon la revendication 1, **caractérisée en ce que**
- la couche selon a) présente une épaisseur de 50 à 250 µm,
- la couche selon b) présente une épaisseur de 15 à 100 µm,
- la couche selon c) présente une épaisseur de 100 à 500 µm,
- la couche selon d) présente une épaisseur de 3 à 40 µm et
- la couche selon e) présente une épaisseur de 15 à 100 µm.

3. Module photovoltaïque, obtenu en utilisant une feuille multicouche selon l'une quelconque des revendications précédentes en tant que revêtement arrière.
